Europäisches Patentamt

European Patent Office

Office européen des brevets

(19)

(11) Veröffentlichungsnummer: **0 458 044 A2**

(12) # EUROPÄISCHE PATENTANMELDUNG

(21) Anmeldenummer: **91105368.4**

(22) Anmeldetag: **04.04.91**

(51) Int. Cl.⁵: **H03K 3/023**

(30) Priorität: **21.05.90 DE 4016316**

(43) Veröffentlichungstag der Anmeldung:
**27.11.91 Patentblatt 91/48**

(84) Benannte Vertragsstaaten:
**DE FR GB IT SE**

(71) Anmelder: **ROBERT BOSCH GmbH**
**Postfach 10 60 50**
**W-7000 Stuttgart 10(DE)**

(72) Erfinder: **Schneider, Thomas, Dipl.-Ing.**
**Gartenstr. 32**
**W-7145 Markgröningen(DE)**

(74) Vertreter: **Kammer, Arno, Dipl.-Ing.**
**ROBERT BOSCH GmbH Zentralstelle**
**Patente-Elektronik 1, Postfach 10 60 50**
**W-7000 Stuttgart 10(DE)**

(54) **Auswerteschaltung für die Signale einer Signalquelle.**

(57) Es wird eine Auswerteschaltung für die Signale eines periodische Signale abgebenden Sensors beschrieben, bei dem dem Komparator zwecks Hysteresebildung abwechselnd unterschiedliche Referenzsignale zum Vergleich mit der Amplitude des Sensorsignals zugeführt werden.

Zur Verbesserung der Störunempfindlichkeit der Schaltung wird jeweils bei Änderung des Ausgangssignals das Referenzsignal auf einen relativ hohen Wert gesetzt, von dem aus es sich zeitabhängig auf einen Minimalwert ändert.

Fig.2

EP 0 458 044 A2

## Stand der Technik

Es sind Auswerteschaltungen gemäß dem Wortlaut des Oberbegriffs des Anspruchs 1 bekannt. Die beiden Referenzsignale sind dort in ihrer Größe fest. Bekanntlich spricht man bei Verwendung zweier Referenzwerte von einer Auswerteschaltung mit Hysterese. Derartige Schaltungen werden benutzt, um zwischen dem Auftreten eines Low- und High-Signals besser unterscheiden zu können.

## Vorteile der Erfindung

Beim Stand der Technik muß die Auswerteschaltung auf das "schlechteste", noch auswertbare Sensorsignal ausgelegt sein und ist damit gegen Störungen sehr empfindlich.

Für die Rad-Geschwindigkeitsbestimmung werden beim ABS Sensoren, die induktiv arbeiten, verwendet. Diese Sensoren liefern eine Spannung, die mit der Frequenz steigt. Um das Signal auswerten zu können, muß es gewandelt werden. Die Schaltung, die diese Aufgabe übernimmt, muß so ausgelegt sein, daß sie das ankommende Signal sicher auswertet, aber gleichzeitig gegen Störungen unempfindlich ist. Eine Anpassung der Eingangsempfindlichkeit an das jeweils ankommende Signal bringt die größte Störsicherheit. Die erfindungsgemäße Auswerteschaltung erfüllt diese Forderung weitgehend.

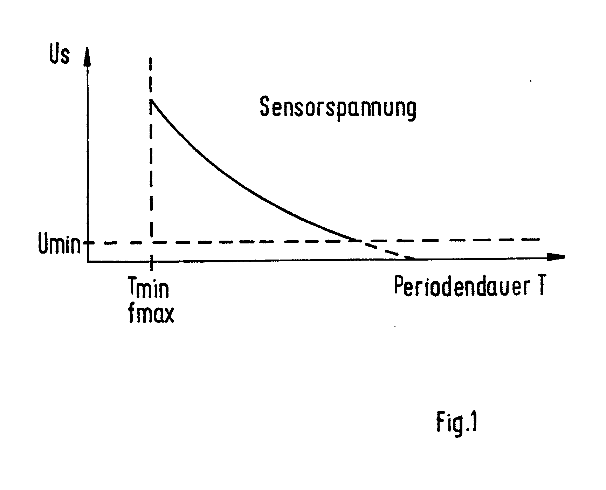

Das vorgeschlagene Konzept arbeitet mit einer "dynamischen" Hysterese. Der Sensor liefert eine Spannung, die in weiten Teilen mit der Frequenz steigt. Dies zeigt Fig. 1, in der die Sensorspannung eines Induktivsensors über der Periodendauer dargestellt ist.

Durch die Einführung der dynamischen Hysterese wird diese Hüllkurve teilweise nachgebildet.

Unmittelbar nach dem Kippen des Komparators hat der Referenzwert einen hohen Wert. Über der Zeit t sinkt der Referenzwert. Wird der Referenzwert vom Sensorsignal überschritten, so kippt sie auf den entgegengesetzten Extremwert. Wird sie nicht überschritten, so sinkt sie auf einen definierten Mininalwert.

Gegenüber dem Bekannten, erreicht man durch die dynamische Hysterese eine wesentlich erhöhte Sicherheit gegenüber einem "Prellen" des Ausgangssignals, hervorgerufen durch ein verrauschtes Eingangssignal. Masseversätze, die durch Schaltvorgänge entstehen, sind nicht mehr so kritisch. Durch entsprechende Auslegung ist eine Unterstützung des Eingangsfilters im niederfrequenten Bereich möglich.

Das dargestellte Prinzip läßt sich immer dann einsetzten, wenn es darum geht, periodische Signale auszuwerten, deren Amplitude mit der Frequenz steigt.

Mit den in den Ansprüchen 3 bis 5 angegebenen Auswerteschaltungen soll eine weitere Verbesserung erzielt werden.

Hiermit sollen Signale ausgewertet werden, die einen unbekannten Offsetanteil haben, die in der Signalamplitude nicht konstant sind, und die relativ klein bezüglich auftretender Störgrößen, sind.

Eine solche Signalquelle stellt z.B. ein aktiver Sensor (z.B. ein Hallsensor oder eine Feldplatte dar, der in einer Zweidrahtschaltung betrieben wird. Durch die Zweidrahtschaltung muß die Signalauswertung über den Sensorstrom erfolgen (kleiner Strom → Low; großer Strom → High).

Die Eigenstromaufnahme des Sensors ergibt im Auswertesignal einen Grundanteil, dessen reale Größe unbekannt ist. Auf diesen Grundanteil wird der Nutzanteil geschaltet. Sind Grund- und Nutzanteil von gleicher Größenordnung, so müssen sie voneinander getrennt werden, um eine sichere Auswertung gewährleisten zu können.

Am Meßwiderstand $R_{Mess}$ der Auswerteschaltung des Anspruchs 4 liegt je nach Signalzustand ein kleiner oder großer positiver Spannungswert. Am Kondensator $C_1$ der Reihenschaltung stellt sich nach der Zeit t das gleiche Potential ein. Für die Zeitkonstante $\tau 1$ des RC-Glieds muß gelten:

$$\tau 1 = R1 * C1 \text{ und } 3 * \tau 1 < = \frac{0.5}{f_{N-Max}} \text{ , wobei}$$

$f_{N-Max}$ die maximale Nutzfrequenz und R1 der Reihenwiderstand des RC-Glieds ist.

Vorteile dieser Schaltung sind:

- Automatische Kompensation des durch die Signalquelle hervorgerufenen Grundanteils. Dieser hat damit keinen Einfluß mehr auf die Auswertesicherheit.
- Maximal mögliche Hysterese des Schaltkomparators. Je nach Systemtoleranzen kann die Hysterese um das z.B. 4-fache größer ausgelegt werden, als bei herkömmlichen Schaltungen.
- Unmittelbar nach dem Kippen des Schaltkomparators ist der Störabstand bis Faktor 2 größer. Dadurch ergibt sich eine weiter verbesserte Störsicherheit. Signalprellen im Schaltpunkt führt nicht zu fehlerhaften Informationen.

Das dargestellte Schaltungsprinzip läßt sich immer dann vorteilhaft einsetzen, wenn Signale mit relativ kleinem Signalhub ausgewertet werden sollen. Die oben beschriebenen Vorteile, im Besonderen die große Hysterese, lassen sich auch bei anderen Signalquellen ausnutzen.

Der Komparator und der zweite und dritte Widerstand stellen in diesem Beispiel entsprechend Anspruch 4 den Komparator mit Hysterese dar.

Die Referenz für den Schaltkomparator ist hier nicht fest eingestellt, wie bei herkömmlichen Auswerteschaltungen, sondern sie paßt sich mit der Zeitkonstante $\tau 1$ dem Sensorsignal an. Dadurch wird erstens der Grundanteil des Signals kompensiert und zweitens kann die Hysterese des Komparators annähernd so groß gewählt werden, wie der minimale Signalhub.

Figurenbeschreibung

Anhand der Zeichnung werden Ausführungsbeispiele der Erfindung näher erläutert. Es zeigen:

Fig. 1    die Abhängigkeit des Sensorsignals von seiner Periodendauer,
Fig. 2    ein Blockschaltbild eines ersten Ausführungsbeispiels der Erfindung,
Fig. 3 und 4    zugehörige Diagramme,
Fig. 5    eine detaillierte Schaltung einer erfindungsgemäßen Auswerteschaltung,
Fig. 6    zugehörige Diagramme.
Fig. 7    eine spezielle Ausbildung der Hysterese Komparators.

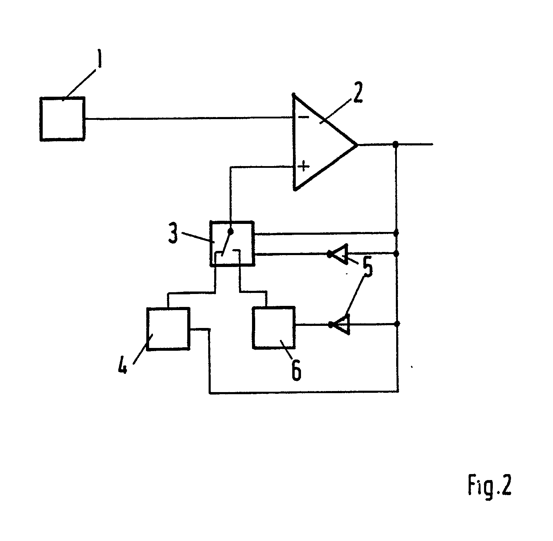

Im Ausführungsbeispiel der Fig. 2 ist mit 1 ein Sensor bezeichnet, der ein periodisches Signal sich ändernder Frequenz an einen Komparator 2 liefert. Im dargestellten Zustand einer Schalteinrichtung 3 ist ein Referenzsignalgeber 4 an den Referenzsignaleingang des Komparators 2 geschaltet. Überschreitet die Größe des Sensorsignals das Referenzsignal aus dem Block 4, so ändert sich das Ausgangssignal des Komparators von high auf low. Hierdurch wird über einen Inverter 5 die Schalteinrichtung 3 umgeschaltet und über einen weiteren Inverter 5 ein Referenzsignalgeber 6 wirksam gemacht.

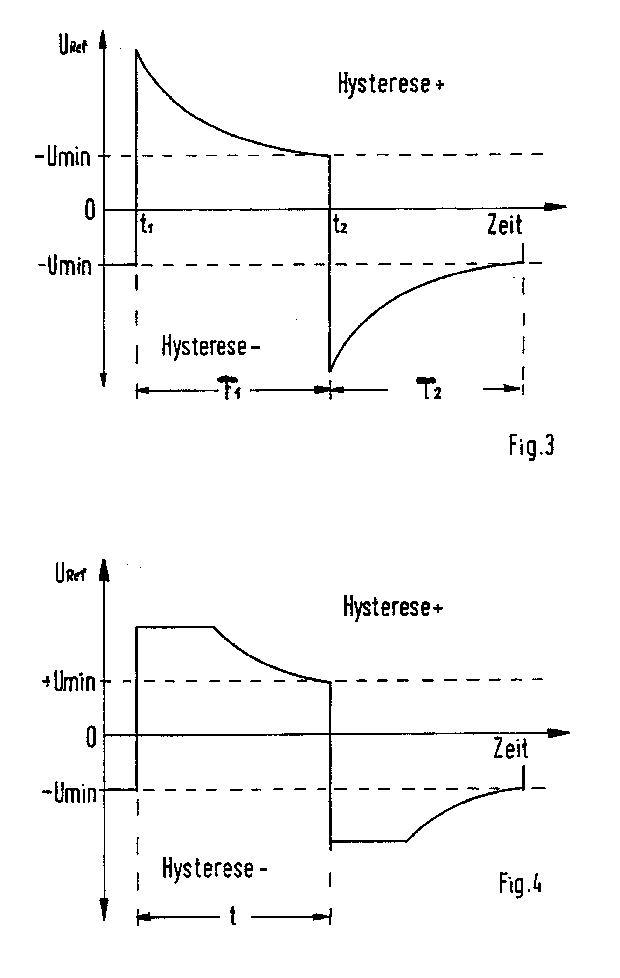

Zugehörige Diagramme zeigen die Fig. 3 und 4, in denen der Verlauf des Referenzsignals über der Zeit gezeigt ist. Hier wird im Zeitpunkt $t_1$ durch das Ausgangssignal des Komparators 2 die Schalteinrichtung 3 in die in Fig. 2 gezeigte Stellung gebracht und der Referenzsignalgeber 4 angesteuert.

Dieser gibt dann den im Zeitraum $T_1$ gezeigten Referenzsignalverlauf ab, bei dem zuerst ein hohes positives Referenzsignal wirksam ist, das dann auf den Signalwert $+U_{min}$ abfällt (Kondensatorentladekurve) und dann konstant bleibt. Im Zeitpunkt $t_2$ erreicht das Sensorsignal das Referenzsignal, wodurch der Komparator sein Ausgangssignal (nicht gezeigt) ändert. Die Signaländerung veranlaßt die Umschaltung der Schalteinrichtung 3 und das Wirksamwerden des Referenzsignalgebers 6, der dann den im Zeitraum $T_2$ gezeigten Referenzsignalverlauf abgibt.

Die Verläufe der Fig. 4 unterscheiden sich hiervon nur dadurch, daß der Signalverlauf nach der Umschaltung zuerst konstant ist und erst nach einer Zeit beginnt auf $+U_{min}$ bzw. $-U_{min}$ abzufallen.

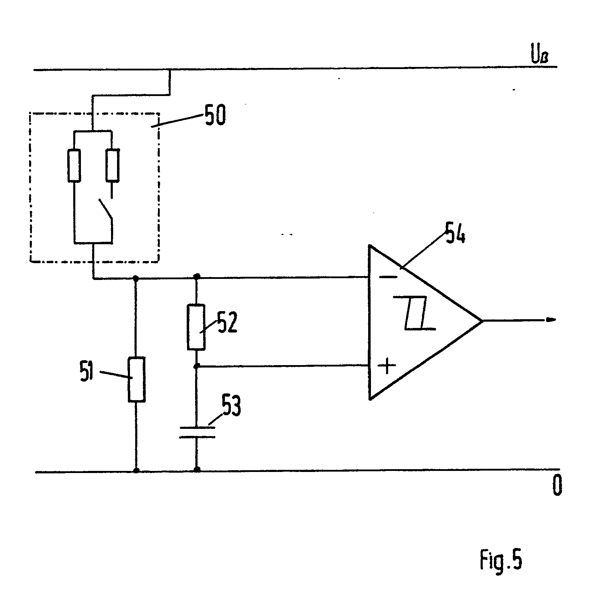

In Fig. 5 ist mit 50 ein aktiver Sensor bezeichnet, der in Reihe mit einem Meßwiderstand 51 zwischen den Polen $U_B$ und 0 einer Gleichspannungsquelle liegt. Der eine im Block 50 gezeigte Widerstand ist der Innenwiderstand des Sensors. Bei Drehung des Rotors wird ein weiterer Widerstand wirksam, der den Widerstandswert herabgesetzt. Parallel zum Meßwiderstand 51 liegt eine RC-Reihenschaltung 52/53. Der Sensor 50 ist mit dem oberen Signaleingang eines Hysterese Komparators 54 verbunden, an dessen Referenzsignaleingang der Zusammenschaltpunkt der RC-Schaltung angeschaltet ist.

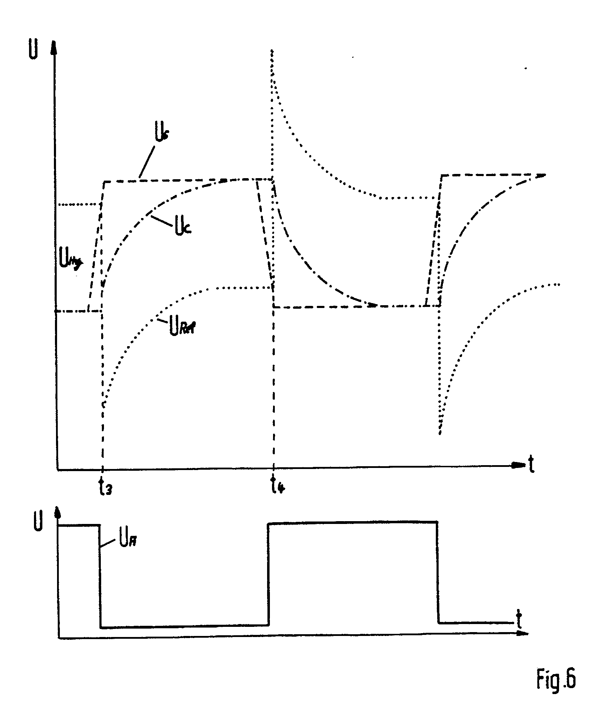

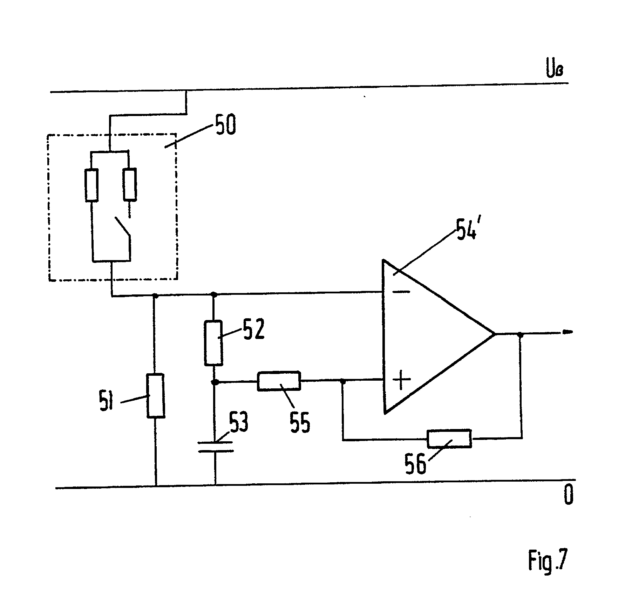

Es ergibt sich folgende Wirkungsweise dieser Schaltung, die anhand der Diagramme der Fig. 6 erläutert werden soll. Das gestrichelt gezeichnete Signal des oberen Diagramms ist die Sensorspannung $U_S$, das strichpunktierte Signal die Spannung $U_C$ am oberen Anschluß des Kondensators 53, das gepunktete Signal die Referenzspannung $U_{Ref}$ und das ausgezogene Signal unten die Ausgangsspannung $U_A$ des Komparators 54. Bei $t_3$ erreicht die Sensorspannung $U_S$ die Referenzspannung $U_{Ref}$. Der Komparator 54 ändert sein Ausgangssignal $U_A$ und gleichzeitig ändert sich hierdurch die Referenzspannung $U_{Ref}$ auf einen anderen Wert. Ebenfalls gleichzeitig beginnt sich die Kondensatorspannung zur Sensorspannung $U_S$ hin zu ändern. Dem durch den Kondensator 53 bewirkten Verlauf der Spannung $U_C$ folgt die $U_{Ref}$. Hat die Spannung $U_C$ die Sensorspannung $U_S$ erreicht, bleiben $U_C$ und $U_{Ref}$ konstant. Bei $t_4$ wiederholt sich der Vorgang mit umgekehrten Vorzeichen. Der Vorgang kann auch nullsymetrisch sein. Fig. 7 zeigt die Schaltung der Fig. 5 mit dem einen Unterschied, daß der Hysterese Kompensator 54 nunmehr in einer Realisierungsvariante mit einem Komparator 54' und zwei Widerständen 55 und 56 dargestellt ist.

Das besondere dieser Schaltung ist einmal, daß die Schaltschwellen keinen festen Wert haben. Sie ergeben sich vielmehr nach folgenden Formeln:

obere Schaltschwelle = $U_S$ Low + $U_{Hy}$. $U_A$ schaltet von Low nach High.

untere Schaltschwelle = $U_S$ High - $U_{Hy}$. $U_A$ schaltet von High nach Low.

Die Schaltungsschwellen sind dabei die Spannungswerte, die vom Sensorsignal über- bzw. unterschritten werden müssen, damit ein Signalwechsel erkannt wird. Man wird die Schaltungen der Fig. 5 und 7 deshalb dort einsetzen, wo das Signal einer Signalquelle stark variieren kann, die Bereiche der low- und high-Signale sich sogar überlappen können. Dadurch, daß jeweils der low- und high-Wert die Schaltschwelle mitbestimmt, ergeben sich auch eindeutige Schaltschwellen sogar für die sich überlappten Bereiche.

Weiterhin kann die Hysterese nun etwa doppelt so groß sein (dynamisch), wie der zu erwartende minimale Signalhub:

$$U_{Hy\ dyn.} = U_{Hy+} - U_{Hy-} < = \underline{2}\ ^* \Delta U_{Smin}$$

$$U_{Hy\ sta.} = U_{Hy+} - U_{Hy-} < = \Delta U_{Smin}$$

$$\Delta U_{Smin} = U_{S\ High\ min} - U_{S\ Low\ max}.$$

## Patentansprüche

1. Auswerteschaltung für die Signale eines periodische Signale abgebenden Signalquelle, enthaltend einen Komparator, dem an seinem einen Eingang die auszuwertenden Signale und an seinem anderen Eingang abwechselnd unterschiedliche Referenzsignale zugeführt werden, und der unterschiedliche Ausgangssignale abgibt in Abhängigkeit davon, welches Referenzsignal vom auszuwertenden Signal überschritten bzw. unterschritten wird, wobei die Umschaltung der Referenzsignale jeweils bei der Änderung des Ausgangssignals erfolgt, dadurch gekennzeichnet, daß die Referenzsignale mit dem Umschalten jeweils auf einen ersten Referenzwert gesetzt werden und sich in Abhängigkeit von der Zeit auf einen zweiten Referenzwert ändern.

2. Auswerteschaltung nach Anspruch 1, dadurch gekennzeichnet, daß der erste Referenzwert zuerst für eine Zeit konstantgehalten wird.

3. Auswerteschaltung nach Anspruch 1 oder 2, dadurch gekennzeichnet, daß der erste und zweite Referenzwert zusätzlich von der Amplitude des auszuwertenden Signals abhängig sind.

4. Auswerteschaltung nach Anspruch 3, dadurch gekennzeichnet, daß parallel zu einem Meßwiderstand, an dem das auszuwertende Signal abfällt, die Reihenschaltung eines Widerstands und eines Kondensators geschaltet ist, daß der Zusammenschaltpunkt der Reihenschaltung mit dem Referenzsignaleingang eines Hysterese-Komparators verbunden ist, dem am andern Eingang das auszuwertende Signal zugeführt wird.

5. Auswerteschaltung nach Anspruch 4, dadurch gekennzeichnet, daß ein aktiver Sensor und der Meßwiderstand in Reihe liegend an die Versorgungsspannung angeschaltet sind.

**Fig.1**

Fig.2

Fig.3

Fig.4

Fig. 5

Fig.6

Fig.7